# FASCICULE DE BREVET EUROPEEN

(11) **EP 3 758 462 B1**
(45) Date de publication et mention de la délivrance du brevet: **05.10.2022**
(21) Numéro de dépôt: 20180922.5
(22) Date de dépôt: 18.06.2020
(51) Int. Cl.: H05K 7/20

(54) **EQUIPEMENT ELECTRIQUE COMPRENANT UN CAPOT ET UN DISSIPATEUR THERMIQUE**
ELEKTROGERÄT, DAS EINE ABDECKUNG UND EINEN KÜHLKÖRPER UMFASST
ELECTRICAL EQUIPMENT COMPRISING A COVER AND A HEAT SINK

(30) Priorité: 25.06.2019 FR 1906863
(43) Date de publication de la demande: 30.12.2020
(73) Titulaire: SAGEMCOM BROADBAND SAS, 92500 Rueil-Malmaison (FR)
(72) Inventeur: CHUSSEAU, Hugo, 92500 RUEIL MALMAISON (FR)
(74) Mandataire: Lavaud, Thomas

(56) Documents cités:
- EP-A1- 3 214 911
- CN-A- 103 411 140
- CN-A- 108 770 307
- CN-A- 109 152 305
- CN-A- 109 168 295
- CN-U- 208 386 836
- US-A- 5 909 358
- US-A1- 2002 101 720
- US-A1- 2018 192 526
- "Integral, structural, natural convection cooled heatsink", RESEARCH DISCLOSURE, février 2001 (2001-02), pages 238-240, XP001103746,

## Description

L'invention concerne le domaine des équipements électriques comprenant un capot et un dissipateur thermique.

### ARRIERE PLAN DE L'INVENTION

De nombreux équipements électriques comprennent une carte électrique sur laquelle sont montés des composants électroniques qui chauffent de manière relativement importante en fonctionnement.

Dans un tel équipement électrique, on utilise un dispositif de refroidissement, par exemple un dissipateur thermique à ailettes, pour refroidir la carte électrique et assurer ainsi que l'équipement électrique fonctionne correctement. Pour être efficace, le dissipateur thermique à ailettes doit présenter une surface de contact importante avec l'air.

De l'art antérieur connu, les documents CN109168295 et CN109152305 décrivent une structure de dissipation thermique d'un composant électronique comprenant un capot, un module d'alimentation et un dissipateur thermique, le module d'alimentation étant fixé au dissipateur thermique pour la conduction thermique; le boîtier électrique étant pourvu d'un orifice de montage, et le dissipateur thermique étant agencé de manière amovible au niveau de l'orifice de montage, de sorte que le démontage et l'assemblage du dissipateur thermique peuvent être réalisés sans ouvrir le capot. Le document US2018192526 décrit un dispositif électronique de commande dans lequel un capot entoure une unité de composants électroniques et dont les bords sont fixés à un dissipateur thermique. Le document US5909358 décrit un clip de dissipateur de chaleur à verrouillage rapide. Le document CN208386836U décrit un boîtier en aluminium d'amplificateur audio intelligent. Le document CN108770307 décrit un dissipateur de chaleur d'alimentation haute performance. Le document CN103411140 décrit une lampe tubulaire à LED supportant un couvercle de lampe avec un substrat de transmission de chaleur auto-serrant. Le document intitulé "Intégral, structural, natural convection cooled heatsink", RESEARCH DISCLOSURE, février 2001 (2001-02), pages 238-240 décrit un capot fixé à un radiateur par emboîtement.

Parmi ces équipements électriques qui nécessitent un dispositif de refroidissement, on trouve notamment certains « objets connectés ».

Les objets connectés sont des équipements électriques qui remplissent un certain nombre de fonctions et qui sont destinés à communiquer via un réseau sans fil, pour être commandés ou bien pour échanger des données, avec un *smartphone,* une tablette ou un ordinateur portable.

Parmi ces objets connectés, on trouve des enceintes intelligentes, des assistants vocaux, des caméras de surveillance, etc.

Les objets connectés présentent souvent un *design* très abouti, sur lequel repose parfois au moins partiellement leur succès commercial. Un objet connecté est ainsi fréquemment muni d'un capot qui s'étend par exemple sur une face de l'objet connecté ou bien qui entoure au moins partiellement l'objet connecté et dont le rôle est, d'une part, bien sûr, de protéger l'intérieur de l'objet connecté, et d'autre part, d'améliorer le *design* de l'objet connecté.

Le capot est donc une pièce décorative qui est fréquemment sensible à l'usure et susceptible de rayer.

Le capot doit donc pouvoir être monté et verrouillé facilement sur l'objet connecté. Ainsi, à la fin de la fabrication de l'objet connecté, au moment de son assemblage final, on limite les risques de dégradation du capot.

De même, pour limiter les risques de dégradation, le capot doit pouvoir être déverrouillé et démonté facilement de l'objet connecté par un service d'après-vente.

### OBJET DE L'INVENTION

L'invention a pour objet un équipement électrique, par exemple un objet connecté, comprenant un dissipateur thermique et un capot qui puisse être monté et démonté facilement.

### RESUME DE L'INVENTION

En vue de la réalisation de ce but, on propose un équipement électrique comprenant un capot, une carte électrique et un dissipateur thermique agencé pour dissiper vers l'extérieur de l'équipement électrique une chaleur produite par la carte électrique, le dissipateur thermique comprenant au moins une ailette libre et deux ailettes de fixation, la ou les ailettes libres étant positionnées entre les ailettes de fixation, le capot présentant une forme générale cylindrique comprenant une ouverture qui s'étend sur toute la longueur du capot, l'ouverture étant définie entre deux extrémités latérales du capot, le capot comprenant deux nervures longitudinales qui s'étendent depuis une surface interne du capot et qui longent chacune un bord d'une extrémité latérale distincte, le capot étant agencé de sorte que, lorsque l'équipement électrique est assemblé, le capot entoure l'équipement électrique et les deux extrémités latérales du capot sont fixées par encliquetage aux deux ailettes de fixation, les nervures longitudinales étant emboîtées élastiquement dans les ailettes de fixation, la ou les ailettes libres s'étendant vers l'extérieur de l'équipement électrique sans être recouvertes par le capot.

Le capot de l'équipement électrique selon l'invention est donc fixé par encliquetage aux ailettes de fixation.

L'encliquetage est une manipulation très simple et beaucoup moins contraignante pour le capot qu'un mode de fixation plus traditionnel, comme le vissage par exemple. Le montage du capot sur ou autour de l'équipement électrique et le verrouillage du capot sont donc réalisés sans endommager le capot. Le déverrouillage et le démontage sont aussi réalisés très facilement.

On note qu'il est possible de dimensionner l'encliquetage de sorte que le capot ne puisse pas être démonté sans outil par l'utilisateur, mais qu'il puisse être démonté rapidement à l'aide d'un outil très simple par un service d'après-vente.

On propose de plus un équipement électrique tel que celui qui vient d'être décrit, dans lequel une forme de chaque nervure longitudinale est complémentaire d'une forme d'une ailette de fixation.

On propose en outre un équipement électrique tel que celui qui vient d'être décrit, dans lequel chaque nervure longitudinale est inclinée vers l'intérieur du capot, et dans lequel chaque ailette de fixation comporte une portion inclinée interne qui est inclinée vers l'intérieur du dissipateur thermique.

On propose de plus un équipement électrique tel que celui qui vient d'être décrit, comprenant un dispositif d'amortissement positionné entre le capot et l'ailette de fixation.

On propose de plus un équipement électrique tel que celui qui vient d'être décrit, dans lequel le dispositif d'amortissement comprend une mousse qui recouvre au moins partiellement l'ailette de fixation.

On propose aussi un équipement électrique tel que celui qui vient d'être décrit, dans lequel le dispositif d'amortissement comprend un tissu qui recouvre au moins partiellement le capot.

On propose de plus un équipement électrique tel que celui qui vient d'être décrit, dans lequel le capot comprend une surface conductrice thermique qui est en contact direct ou indirect avec au moins une ailette de fixation, de sorte que le capot contribue à la dissipation vers l'extérieur de l'équipement électrique de la chaleur produite par la carte électrique.

On propose de plus un équipement électrique tel que celui qui vient d'être décrit, l'équipement électrique étant une enceinte intelligente.

On propose en outre un procédé de montage d'un équipement électrique tel que celui qui vient d'être décrit, comprenant les étapes de :
- monter la carte électrique et le dissipateur thermique ;
- écarter les deux extrémités latérales du capot ;
- entourer l'équipement électrique avec le capot ;
- fixer par encliquetage les deux extrémités latérales du capot aux deux ailettes de fixation.

On propose aussi un procédé de démontage d'un équipement électrique tel que celui qui vient d'être décrit, comprenant les étapes de :
- désencliqueter des deux ailettes de fixation les deux extrémités latérales du capot ;
- retirer le capot de l'équipement électrique.

L'invention sera mieux comprise à la lumière de la description qui suit d'un mode de mise en œuvre particulier.

### BREVE DESCRIPTION DES DESSINS

Il sera fait référence aux dessins annexés, parmi lesquels :
[Fig. 1] la figure 1 est une vue en perspective d'un équipement électrique selon l'invention, qui est ici une enceinte intelligente ;
[Fig. 2] la figure 2 est une vue en coupe et simplifiée de l'enceinte intelligente, selon un plan perpendiculaire à une hauteur de l'enceinte intelligente ;
[Fig. 3] la figure 3 est une vue en perspective du dissipateur thermique de l'enceinte intelligente ;
[Fig. 4] la figure 4 est une vue de détail de la figure 2 ;
[Fig. 5] la figure 5 est une vue similaire à celle de la figure 4, le capot n'étant pas recouvert de tissu et les ailettes de fixation n'étant pas recouvertes de mousse ;
[Fig. 6] la figure 6 est une vue similaire à celle de la figure 5, le capot n'étant pas représenté ;
[Fig. 7] la figure 7 est une vue en perspective du capot de l'enceinte intelligente ;
[Fig. 8] la figure 8 est une vue en coupe des extrémités latérales du capot, selon un plan perpendiculaire à une longueur du capot.

### DESCRIPTION DETAILLEE DE L'INVENTION

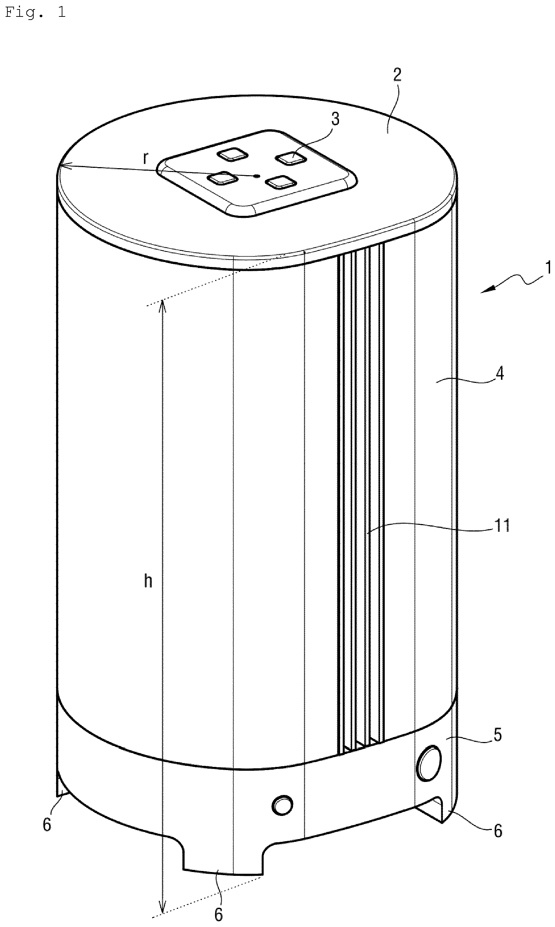

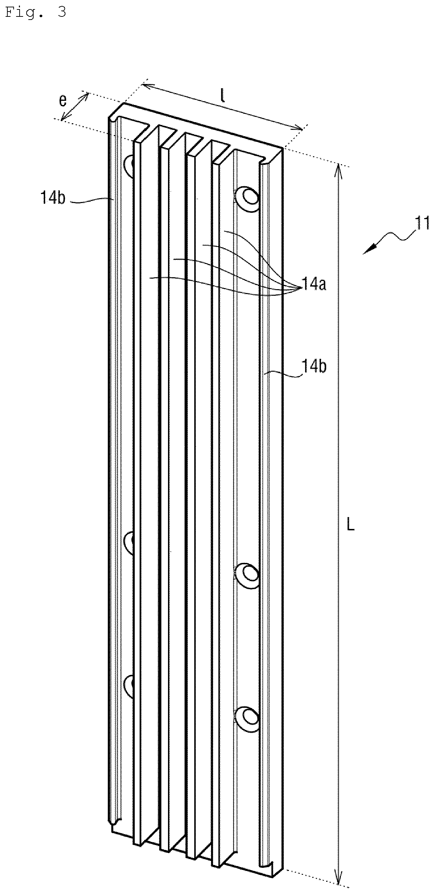

En référence aux figures 1 à 3, l'équipement électrique selon l'invention est ici une enceinte intelligente 1 qui, de manière classique, comporte une pluralité de haut-parleurs, des moyens de génération de signaux électriques acquis par les haut-parleurs et à partir desquels les haut-parleurs produisent des signaux sonores, et des moyens de communication sans fil permettant à l'enceinte intelligente 1 de communiquer via un réseau sans fil.

L'enceinte intelligente 1 a pour forme générale un cylindre ayant pour section un disque de rayon r dont la circonférence présente une portion angulaire aplatie.

La hauteur h de l'enceinte intelligente 1 est supérieure à son rayon r.

L'enceinte intelligente 1 comprend une plaque supérieure 2 située au niveau d'une face supérieure de l'enceinte intelligente 1. La plaque supérieure 2 comprend des boutons de commande 3 de l'enceinte intelligente 1.

L'enceinte intelligente 1 comprend une face arrière 4 définie par la portion angulaire aplatie de la circonférence de sa section. L'enceinte intelligente 1 comprend aussi une base inférieure 5 qui comporte des pieds 6 permettant de poser l'enceinte intelligente 1 sur un support plat.

L'enceinte intelligente 1 comprend aussi un châssis interne, non représenté, qui s'étend entre la plaque supérieure 2 et la base inférieure 5. Certains des haut-parleurs sont fixés au châssis interne.

L'enceinte intelligente 1 comporte de plus une carte électrique 10. La carte électrique 10 comprend une pluralité de composants électroniques (non représentés) susceptibles de chauffer en fonctionnement.

L'enceinte intelligente 1 comporte aussi un dissipateur thermique 11 destiné à dissiper vers l'extérieur de l'enceinte intelligente 1 une chaleur produite par la carte électrique 10.

Le dissipateur thermique 11 est ici fabriqué en aluminium, par extrusion. Bien sûr, tout matériau conducteur thermique et tout procédé de fabrication peuvent être utilisés pour fabriquer le dissipateur thermique 11.

Le dissipateur thermique 11 présente une forme allongée et peu épaisse : la longueur L du dissipateur thermique 11 est supérieure à sa largeur 1 qui est supérieure à son épaisseur e.

Le dissipateur thermique 11 comprend une base 12, une portion courante 13 et des ailettes 14, qui s'étendent successivement dans son épaisseur e. La base 12 ne s'étend pas sur toute la longueur L du dissipateur thermique 11, mais seulement sur certaines portions de celle-ci.

Les ailettes 14 s'étendent depuis la portion courante 13 perpendiculairement à celle-ci, et parallèlement à la longueur L du dissipateur thermique 11.

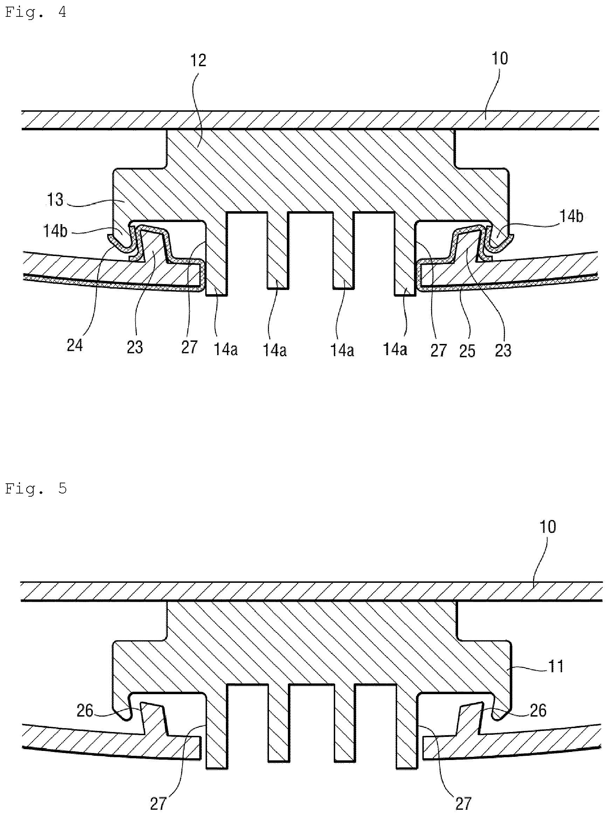

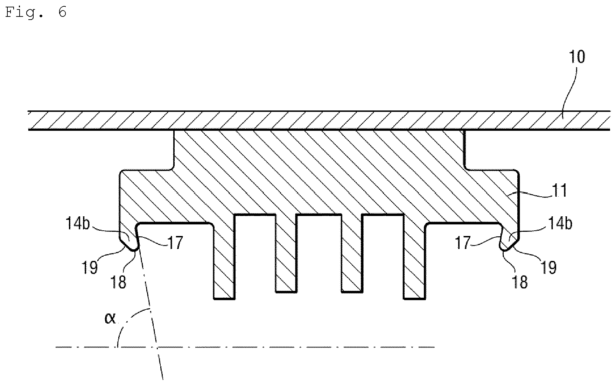

En référence aux figures 4 à 6, les ailettes 14 comprennent au moins une, en l'occurrence quatre ailettes libres 14a et au moins une, en l'occurrence deux ailettes de fixation 14b. Les ailettes libres 14a sont positionnées entre les ailettes de fixation 14b, les ailettes de fixation 14b étant positionnées aux extrémités (selon la largeur 1) du dissipateur thermique 11.

Chaque ailette de fixation 14b comprend une portion inclinée interne 17 positionnée du côté de l'intérieur du dissipateur thermique 11 (c'est-à-dire en regard de l'ailette libre 14a adjacente), une portion arrondie 18 et une portion inclinée externe 19 positionnée du côté de l'extérieur du dissipateur thermique 11. La portion inclinée interne 17 est légèrement inclinée vers l'intérieur du dissipateur thermique 11, et donc vers les ailettes libres 14a, d'un angle α par rapport à une direction parallèle à la largeur 1 du dissipateur thermique 11, l'angle α étant inférieur à 90°. La portion arrondie 18 et la portion inclinée externe 19 constituent l'extrémité de l'ailette de fixation 14b. L'ailette de fixation 14b forme ainsi un crochet orienté vers l'intérieur du dissipateur thermique 11.

Les ailettes de fixation 14b sont recouvertes d'une mousse 24. La mousse 24 recouvre les ailettes de fixation 14b sur toute leur longueur, ou bien seulement sur des portions de leur longueur.

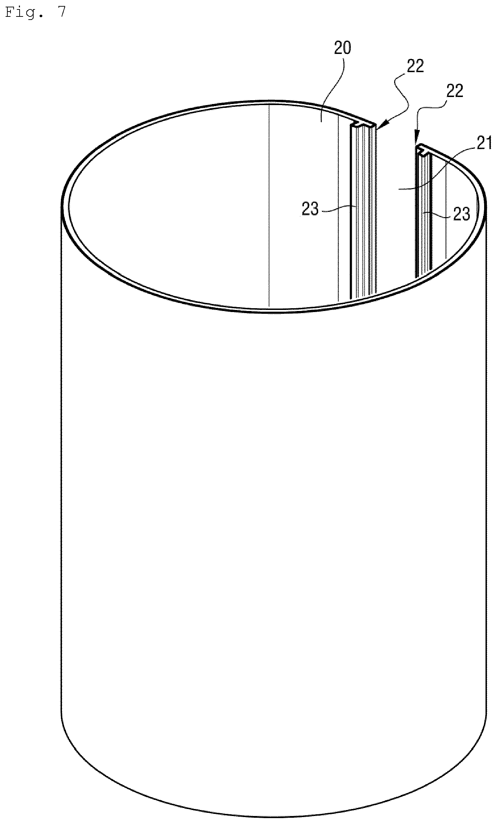

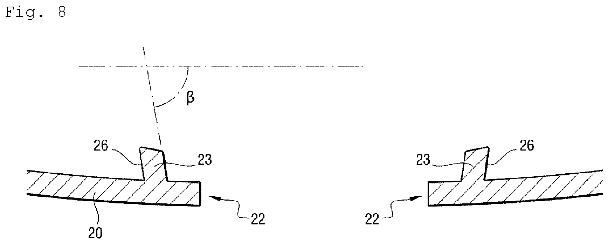

En référence aux figures 7 et 8, l'enceinte intelligente 1 comporte aussi un capot 20. Le capot 20 présente une forme générale cylindrique, ayant pour section un cercle de rayon r dont la circonférence présente une portion angulaire aplatie : c'est le capot 20 qui confère sa forme extérieure à l'enceinte intelligente 1.

Le capot 20 est fabriqué en une matière plastique.

Le capot 20 comprend une ouverture 21 qui s'étend sur toute la longueur du capot 20, l'ouverture 21 étant définie entre deux extrémités latérales 22 du capot 20.

Le capot 20 présente, du fait de sa matière et du fait de l'ouverture 21, une certaine élasticité.

Le capot 20 comprend deux nervures longitudinales 23 qui s'étendent chacune depuis une surface interne du capot 20. Chaque nervure longitudinale 23 est positionnée à proximité d'un bord d'une extrémité latérale 22 distincte et longe le bord de ladite extrémité latérale 22. Chaque nervure longitudinale 23 est inclinée vers l'intérieur du capot 20 (c'est-à-dire vers le côté opposé à l'ouverture 21), par rapport à la surface interne du capot 20, d'un angle β. L'angle β est inférieur à 90° et est égal à l'angle a. La forme de chaque nervure longitudinale 23 est donc complémentaire de la forme d'une ailette de fixation 14b.

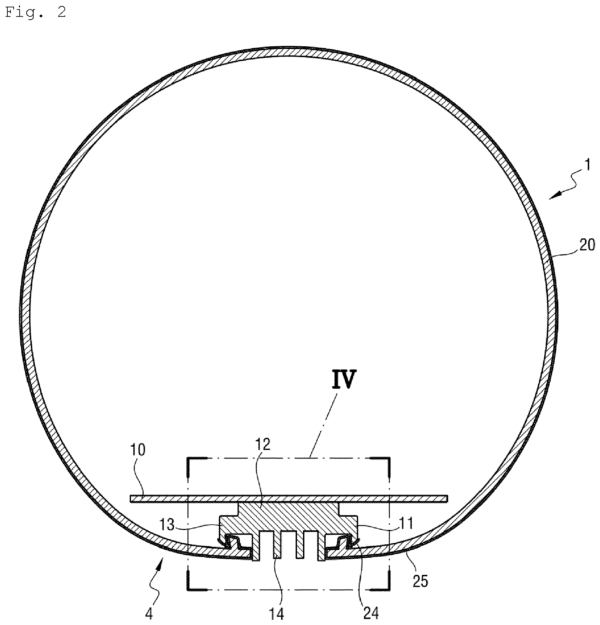

Toute la surface externe du capot 20, ainsi qu'une bande étroite de la surface interne longeant tous les bords du capot 20, sont recouvertes d'un tissu 25 (visible sur les figures 2 et 4). En particulier, les deux nervures axiales 23 sont recouvertes du tissu 25.

On décrit maintenant, en référence aux figures, certaines étapes du montage de l'enceinte intelligente 1 et la manière dont les éléments qui viennent d'être décrits sont assemblés.

La carte électrique 10 est tout d'abord positionnée à proximité de la face arrière 4 de l'enceinte intelligente 1 parallèlement à la forme aplatie de la face arrière 4. La carte électrique 10 est par exemple fixée au châssis interne de l'enceinte intelligente 1.

Le dissipateur thermique 11 est alors installé. Le dissipateur thermique 11 est fixé au châssis interne de l'enceinte intelligente 1 en étant intercalé verticalement entre la plaque supérieure 2 et la base inférieure 5.

Le dissipateur thermique 11 est positionné entre la face arrière 4 et la carte électrique 10. La base 12 du dissipateur thermique 11 est en contact indirect avec la carte électrique 10 : un matériau conducteur thermique souple (non représenté) est positionné entre la carte électrique 10 et la base 12 du dissipateur thermique 11.

On note ici qu'il n'est pas nécessaire que le contact soit indirect, et qu'il serait possible de mettre directement en contact la carte électrique 10 (ou en tout cas un composant électronique) et le dissipateur thermique 11.

Le dissipateur thermique 11 se situe au niveau d'une portion centrale de la face arrière 4, en étant parallèle à celle-ci. La longueur L du dissipateur thermique 11 est parallèle à la hauteur h de l'enceinte intelligente 1. Ici, le dissipateur thermique 11 s'étend sur (presque) toute la hauteur h de l'enceinte intelligente 1, à l'exception de la hauteur de la base 5 et de la hauteur de la plaque supérieure 2. Les ailettes 14 du dissipateur thermique 11 sont toutes orientées vers l'extérieur de l'enceinte intelligente 1.

On monte alors le capot 20. Pour cela, on écarte légèrement les deux extrémités latérales 22 et on positionne le capot 20 de sorte qu'il entoure l'enceinte intelligente 1.

Les deux extrémités latérales 22 du capot 20 sont fixées par encliquetage sur les deux ailettes de fixation 14b. Les nervures longitudinales 23 sont emboîtées élastiquement dans les ailettes de fixation 14b, le tissu 25 sur la face interne 26 de chaque nervure de longitudinale 23 étant en contact avec la mousse 24 qui recouvre la portion inclinée interne 17 de l'ailette de fixation 14b correspondante.

On remarque que le bord de chaque extrémité latérale 22 ou, plus exactement, le tissu 25 qui recouvre le bord, est en contact avec une face plane externe 27 de l'ailette libre 14a adjacente de l'ailette de fixation 14b correspondante. Cette configuration contribue à maintenir le capot 20 en position.

Le capot 20 est ainsi fixé et verrouillé à l'enceinte intelligente 1.

Les ailettes libres 14a du dissipateur thermique 11 sont ainsi positionnées entre les extrémités latérales 22 du capot 20 et s'étendent vers l'extérieur de l'enceinte intelligente 1, perpendiculairement à la face arrière 4, sans être recouvertes par le capot 20. Cette configuration permet d'assurer une dissipation par convection vers l'extérieur, très efficace, de la chaleur produite par la carte électrique 10.

Pour démonter le capot 20, il suffit de désencliqueter des deux ailettes de fixation 14b les deux extrémités latérales 22 du capot 20. On retire alors le capot 20 de l'enceinte intelligente 1.

On remarque que l'enceinte intelligente 1 comprend un dispositif d'amortissement comprenant deux moyens d'amortissement : la mousse 24 et le tissu 25.

Le dispositif d'amortissement permet d'amortir les vibrations et les éventuels bruits générés lors du fonctionnement de l'enceinte intelligente 1 au niveau de l'interface entre le capot 20 et le dissipateur thermique 11.

On note qu'un seul moyen d'amortissement peut être suffisant.

Avantageusement, on peut prévoir que le capot 20 comprenne une surface conductrice thermique (par exemple métallique) qui soit contact avec au moins une ailette de fixation 14b. Le capot 20 contribue de la sorte à la dissipation vers l'extérieur de l'enceinte intelligente 1 de la chaleur produite par la carte électrique 10. Le contact entre la surface conductrice thermique du capot 20 et l'ailette de fixation 14b est un contact direct ou bien indirect, c'est-à-dire via un matériau conducteur thermique. Ce matériaux conducteur thermique peut lui-même être un moyen d'amortissement.

Bien entendu, l'invention n'est pas limitée au mode de réalisation décrit mais englobe toute variante entrant dans le champ de l'invention telle que définie par les revendications.

L'invention ne s'applique bien sûr pas uniquement à un capot qui entoure un équipement électrique, mais à tout type de capot de toute forme, fixé à un dissipateur thermique.

Le dispositif d'encliquetage peut être différent. En particulier, le ou les crochets peuvent se trouver sur le capot et non sur le dissipateur thermique. Le capot pourrait être encliqueté sur une seule ailette de fixation.

De même, le dispositif d'amortissement peut être différent.

L'équipement électrique selon l'invention n'est pas nécessairement une enceinte intelligente : l'invention s'applique à tout type d'objet connecté et, plus généralement, à tout type d'équipement électrique.

## Revendications

1. Equipement électrique comprenant un capot (20), une carte électrique (10) et un dissipateur thermique (11) agencé pour dissiper vers l'extérieur de l'équipement électrique (1) une chaleur produite par la carte électrique (10), le dissipateur thermique comprenant au moins une ailette libre (14a) et deux ailettes de fixation (14b), la ou les ailettes libres (14a) étant positionnées entre les ailettes de fixation, le capot (20) présentant une forme générale cylindrique comprenant une ouverture (21) qui s'étend sur toute la longueur du capot (20), l'ouverture étant définie entre deux extrémités latérales (22) du capot, le capot comprenant deux nervures longitudinales (23) qui s'étendent depuis une surface interne du capot (20) et qui longent chacune un bord d'une extrémité latérale (22) distincte, le capot étant agencé de sorte que, lorsque l'équipement électrique (1) est assemblé, le capot (20) entoure l'équipement électrique (1) et les deux extrémités latérales (22) du capot (20) sont fixées par encliquetage aux deux ailettes de fixation (14b), les nervures longitudinales étant emboîtées élastiquement dans les ailettes de fixation, la ou les ailettes libres (14a) s'étendant vers l'extérieur de l'équipement électrique sans être recouvertes par le capot (20) .

2. Equipement électrique selon la revendication 1, une forme de chaque nervure longitudinale (23) étant complémentaire d'une forme d'une ailette de fixation (14b).

3. Equipement électrique selon la revendication 2, dans lequel chaque nervure longitudinale (23) est inclinée vers l'intérieur du capot, et dans lequel chaque ailette de fixation (14b) comporte une portion inclinée interne (17) qui est inclinée vers l'intérieur du dissipateur thermique (11) .

4. Equipement électrique selon l'une des revendications précédentes, comprenant un dispositif d'amortissement positionné entre le capot (20) et l'ailette de fixation (14b).

5. Equipement électrique selon la revendication 4, dans lequel le dispositif d'amortissement comprend une mousse (24) qui recouvre au moins partiellement l'ailette de fixation (14b).

6. Equipement électrique selon la revendication 4, dans lequel le dispositif d'amortissement comprend un tissu (25) qui recouvre au moins partiellement le capot.

7. Equipement électrique selon l'une des revendications précédentes, dans lequel le capot (20) comprend une surface conductrice thermique qui est en contact direct ou indirect avec au moins une ailette de fixation (14b), de sorte que le capot (20) contribue à la dissipation vers l'extérieur de l'équipement électrique (1) de la chaleur produite par la carte électrique (10).

8. Equipement électrique selon l'une des revendications précédentes, l'équipement électrique étant une enceinte intelligente.

9. Procédé de montage d'un équipement électrique selon l'une des revendications précédentes, comprenant les étapes de :
- monter la carte électrique (10) et le dissipateur thermique (11) ;
- écarter les deux extrémités latérales (22) du capot (20) ;
- entourer l'équipement électrique (1) avec le capot ;
- fixer par encliquetage les deux extrémités latérales (22) du capot aux deux ailettes de fixation (14b).

10. Procédé de démontage d'un équipement électrique selon la revendication 3, comprenant les étapes de :
- désencliqueter des deux ailettes de fixation (14b) les deux extrémités latérales (22) du capot (20) ;
- retirer le capot (20) de l'équipement électrique (1).

## Patentansprüche

1. Elektrische Ausrüstung, umfassend eine Abdeckung (20), eine Leiterplatte (10) und einen Kühlkörper (11), der ausgebildet ist, um von der Leiterplatte (10) erzeugte Wärme nach außerhalb der elektrischen Ausrüstung (1) abzuführen, wobei der Kühlkörper mindestens eine freie Finne (14a) und zwei Befestigungsfinnen (14b) umfasst, wobei die freie Finne oder die freien Finnen (14a) zwischen den Befestigungsfinnen positioniert sind, wobei die Abdeckung (20) eine allgemeine zylindrische Form aufweist, die eine Öffnung (21) umfasst, die sich über die gesamte Länge der Abdeckung (20) erstreckt, wobei die Öffnung zwischen zwei seitlichen Enden (22) der Abdeckung definiert ist, wobei die Abdeckung zwei Längsrippen (23) umfasst, die sich ab einer Innenfläche der Abdeckung (20) erstrecken und jeweils an einem Rand eines gesonderten seitlichen Endes (22) entlanglaufen, wobei die Abdeckung derart ausgebildet ist, dass, wenn die elektrische Ausrüstung (1) zusammengebaut ist, die Abdeckung (20) die elektrische Ausrüstung (1) umschließt und die beiden seitlichen Enden (22) der Abdeckung (20) durch Einrasten an den beiden Befestigungsfinnen (14b) befestigt sind, wobei die Längsrippen elastisch in die Befestigungsfinnen eingefügt sind, wobei sich die freie Finne oder die freien Finnen (14a) nach außerhalb der elektrischen Ausrüstung erstrecken, ohne von der Abdeckung (20) abgedeckt zu sein.

2. Elektrische Ausrüstung nach Anspruch 1, wobei eine Form jeder Längsrippe (23) komplementär zu einer Form einer Befestigungsfinne (14b) ist.

3. Elektrische Ausrüstung nach Anspruch 2, bei der jede Längsrippe (23) zur Innenseite der Abdeckung geneigt ist und bei der jede Befestigungsfinne (14b) einen inneren geneigten Abschnitt (17) umfasst, der zur Innenseite des Kühlkörpers (11) geneigt ist.

4. Elektrische Ausrüstung nach einem der vorhergehenden Ansprüche, umfassend eine Dämpfungsvorrichtung, die zwischen der Abdeckung (20) und der Befestigungsfinne (14b) positioniert ist.

5. Elektrische Ausrüstung nach Anspruch 4, bei der die Dämpfungsvorrichtung einen Schaumstoff (24) umfasst, der die Befestigungsfinne (14b) zumindest teilweise abdeckt.

6. Elektrische Ausrüstung nach Anspruch 4, bei der die Dämpfungsvorrichtung ein Gewebe (25) umfasst, das die Abdeckung zumindest teilweise abdeckt.

7. Elektrische Ausrüstung nach einem der vorhergehenden Ansprüche, bei der die Abdeckung (20) eine wärmeleitende Oberfläche umfasst, die in direktem oder indirektem Kontakt mit mindestens einer Befestigungsfinne (14b) steht, derart, dass die Abdeckung (20) zur Abführung der von der Leiterplatte (10) erzeugten Wärme nach außerhalb der elektrischen Ausrüstung (1) beiträgt.

8. Elektrische Ausrüstung nach einem der vorhergehenden Ansprüche, wobei die elektrische Ausrüstung ein intelligenter Lautsprecher ist.

9. Montageverfahren zur Montage einer elektrischen Ausrüstung nach einem der vorhergehenden Ansprüche, umfassend die Schritte:
- Montieren der Leiterplatte (10) und des Kühlkörpers (11);
- Spreizen der beiden seitlichen Enden (22) der Abdeckung (20);
- Umschließen der elektrischen Ausrüstung (1) mit der Abdeckung;
- Befestigen der beiden seitlichen Enden (22) der Abdeckung an den beiden Befestigungsfinnen (14b) durch Einrasten.

10. Verfahren zur Demontage einer elektrischen Ausrüstung nach Anspruch 3, umfassend die Schritte:
- Ausrasten der beiden seitlichen Enden (22) der Abdeckung (20) aus den beiden Befestigungsfinnen (14b);
- Abziehen der Abdeckung (20) von der elektrischen Ausrüstung (1).

## Claims

1. Electrical equipment comprising a cover (20), a circuit board (10), and a heatsink (11) arranged to dissipate heat produced by the circuit board (10) outwards from the electrical equipment (1), the heatsink comprising at least one free fin (14a) and two fastener fins (14b), the free fin(s) (14a) being positioned between the fastener fins, the cover (20) being generally cylindrical in shape, having an opening (21) that extends over the entire length of the cover (20), the opening being defined between two lateral ends (22) of the cover, the cover comprising two longitudinal splines (23) that extend from an inside surface of the cover (20) and each of which runs along an edge of a respective one of the lateral ends (22), the cover being arranged in such a manner that, when the electrical equipment (1) is assembled, the cover (20) surrounds the electrical equipment (1) and the two lateral ends (22) of the cover (20) are snap-fastened to the two fastener fins (14b), the longitudinal splines being resiliently engaged with the fastener fins, the free fin(s) (14a) extend(s) outwards from the electrical equipment without being covered by the cover (20).

2. The electrical equipment according to claim 1, the shape of each longitudinal spline (23) being complementary to the shape of a fastener fin (14b).

3. The electrical equipment according to claim 2, wherein each longitudinal spline (23) slopes towards the inside of the cover, and wherein each fastener fin (14b) comprises an internal sloping portion (17) that slopes towards the inside of the heatsink (11).

4. The electrical equipment according to any one of the preceding claims, including a damper device positioned between the cover (20) and the fastener fin (14b) .

5. The electrical equipment according to claim 4, wherein the damper device comprises foam (24) that covers the fastener fin (14b), at least in part.

6. The electrical equipment according to claim 4, wherein the damper device comprises fabric (25) that covers the cover, at least in part.

7. The electrical equipment according to any one of the preceding claims, wherein the cover (20) comprises a thermally conductive surface that is in direct or indirect contact with at least one fastener fin (14b), such that the cover (20) contributes to dissipating the heat produced by the circuit board (10) outwards from the electrical equipment (1).

8. The electrical equipment according to any one of the preceding claims, the electrical equipment being a smart speaker.

9. A method of constructing electrical equipment according to any one of the preceding claims, the method comprising the steps of:
• installing the circuit board (10) and the heatsink (11);
• spacing apart the two lateral ends (22) of the cover (20);
• surrounding the electrical equipment (1) with the cover;
• snap-fastening the two lateral ends (22) of the cover onto the two fastener fins (14b).

10. A method of dismantling electrical equipment according to claim 3, the method comprising the steps of:
• undoing the snap-fastening between the two fastener fins (14b) and the two lateral ends (22) of the cover (20);
• removing the cover (20) from the electrical equipment (1).
